# EUROPEAN PATENT APPLICATION

(11) **EP 0 749 154 A2**
(43) Date of publication of application: **18.12.1996**
(21) Application number: 96105482.2
(22) Date of filing: 04.04.1996
(51) Int. Cl.: H01L 21/20

(54) **Method of fabricating a III-V compound semiconductor layer**

(30) Priority: 14.06.1995 JP 147601/95
(71) Applicant: MITSUBISHI DENKI KABUSHIKI KAISHA, Tokyo 100 (JP)
(72) Inventor: Motoda, Takashi, c/o Mitsubishi Denki K.K., Tokyo 100 (JP); Kato, Manabu, c/o Mitsubishi Denki K.K., Tokyo 100 (JP)
(74) Representative: Bohnenberger, Johannes, Dr.

(57) **Abstract**

A method for fabricating a semiconductor device comprises preparing a semiconductor substrate (1) having a surface with partial regions whose temperatures are different from one another; growing a III-V group compound semiconductor layer on the surface of the semiconductor substrate (1), so that the respective partial regions (141, 142) of the semiconductor layer have different compositions. The compositions of the semiconductor layers in the partial regions (141, 142) can be controlled with high precision. In addition, since the surface of the semiconductor layer after the growth becomes flat, the fabricating method of the semiconductor device after the growth of the semiconductor layer can be made stable.

## Description

### FIELD OF THE INVENTION

The present invention relates to a method for fabricating a semiconductor device and a semiconductor device. More particularly, this invention relates to a method for fabricating a semiconductor device in which a laser element and an optical modulator is integrated and such a semiconductor device that is fabricated thereby.

### BACKGROUND OF THE INVENTION

Accompanying with an increased degree and an increased function of various kinds of systems for opto-electronics applications, high integration is required for semiconductor devices which are employed therefor. In this semiconductor device, it is necessary to connect optical waveguides of the laser element and the optical modulator which are fabricated separately, and various difficulties accompany therewith.

Therefore, a method of performing the growth of semiconductor layers constituting the laser element and the optical modulator, respectively, simultaneously to form optical waveguides monolithically integrated with each other is proposed. A description is given of an example of such a method.

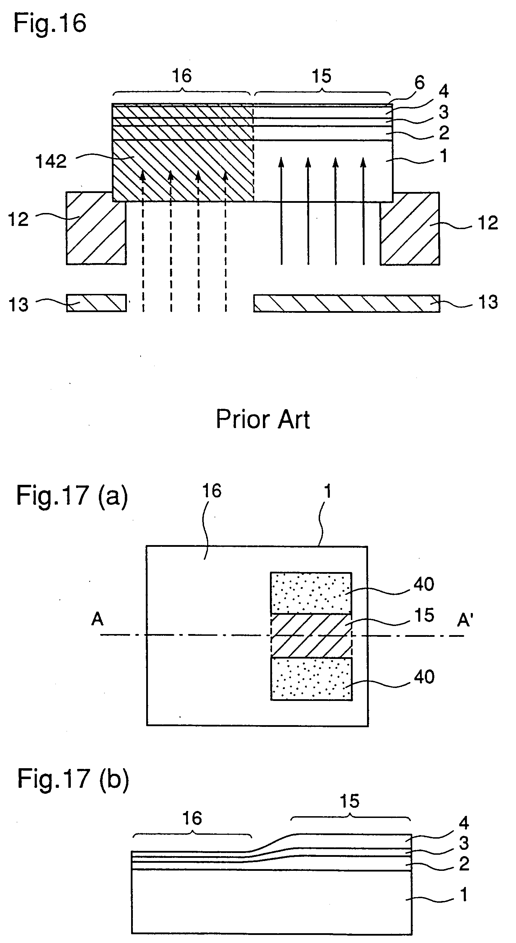

First, in the step of figure 17(a), silicon dioxide films 40 are formed on regions on both sides of the region 15 where a laser element is to be formed on an n type InP substrate 1, and on the region other than the regions where the silicon dioxide films 40 are formed, an n type InP cladding layer 2, a multi-quantum well (MQW) structure active layer 3, and a p type InP cladding layer 4 are selectively grown by MOCVD. Meanwhile, the growth speed of semiconductor layers in the region 15 put between the silicon oxide layers 40 is larger than the growth speed in the region other than this region. Therefore, the cross-section in line A-A' in figure 17(a) after these semiconductor layers are grown are as shown in figure 17(b), and the thickness of the quantum well layer of the MQW active layer is larger than that in the light modulator. Accordingly, the energy difference between the bottom level in the conduction band and the bottom level in the valence band of this quantum well becomes larger in the light modulator than in the laser element. Accordingly, when the voltage applied between electrodes of the light modulator is zero, the light oscillated in the laser element is not absorbed by the light modulator. However, in order to realize a semiconductor laser with light modulator, the thickness of the quantum well layer should be controlled to such a thickness that can absorb the light from the laser element by the light modulator by the quantum-confinement Stark effect (hereinafter referred to as QCSE effect) when an appropriate reverse bias is applied to the light modulator. Since the growth speed of semiconductor layers of a laser element can be varied in accordance with the interval of the silicon dioxide films 40 and the widths of the respective silicon dioxide films, the control of the thickness of the quantum well layer is possible.

In the prior art semiconductor laser device with light modulator, it is effective to make the energy difference between the bottom level in the conduction band of the quantum well and the bottom level in the valence band of the quantum well of the MQW active layer smaller in order to enhance the absorption efficiency of light in the light modulator. In order to realize that, the quantum well layer is preferred to be thick. However, but it is impossible to make the quantum well layer of the laser element thicker than the quantum well layer of the light modulator region, therefore, it is preferable to make the energy difference in the light modulator close to that of the energy difference in the laser element as much as possible. However, a precise control of the thickness of the well layer is difficult as far as the above-described selective growth method is employed, and the energy difference in the light modulator is required to be made to larger than that in the laser element at least to some degree with paying considerations on the variations in the thicknesses of the quantum well layer. This determines the limitations on the light absorption efficiency in the light modulator. Accordingly, it is difficult to increase the attenuation light ratio in the light modulator, i.e., ratio of transmission light intensity in a state where no bias voltage is applied to transmission light intensity in a state where a reverse bias voltage is applied.

As shown in figure 17(b), a step is generated between the laser element region and the light modulator region on the surface after the semiconductor layers are grown, which makes the fabricating processes which are to be carried out thereafter unstable.

In addition, because both of the wavelength of oscillating light of the laser element and the wavelength range of the light that is absorbed by the light modulator have to be controlled by the thickness of the quantum well layer, the degree of freedom in the design of the laser device was low.

### SUMMARY OF THE INVENTION

It is an object of the present invention to provide a method for fabricating a semiconductor device that fabricates a semiconductor device in which the attenuation light ratio of a light modulator is increased, a semiconductor laser element and a light modulator is fabricated by a stable fabricating process having a large degree of freedom in designating the device, and further in which a semiconductor laser element and the light modulator are integrated with each other.

It is another object of the present invention to provide a semiconductor device that is fabricated by the above-described fabrication method.

Other objects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

According to a first aspect of the present invention, a method for fabricating a semiconductor device comprises: preparing a semiconductor substrate having a surface which has partial regions whose temperatures are different from one another; growing a III-V group compound semiconductor layer on the surface of the semiconductor substrate, so that the partial regions of the semiconductor layer having different compositions from one another. Therefore, the compositions of the semiconductor layers in the partial regions can be controlled with high precision. In addition, since the surface of the semiconductor layer after the growth becomes flat, the fabricating method of the semiconductor device after the growth of the semiconductor layer can be made to a stable one. Further, by that the composition of the semiconductor layer can be controlled independently for the respective partial regions, the degree of freedom in designing the semiconductor device can be largely enhanced.

According to a second aspect of the present invention, in the above-described fabricating method of a semiconductor device, the growth of the III-V group compound semiconductor layer is carried out by metal organic chemical vapor deposition. Therefore, the dissociation efficiency of V group element in the respective partial regions are made to different ones for respective partial regions, thereby the compositions of the III-V group compound semiconductor layer can be controlled for the respective regions with high precision. In addition, since the surface of the semiconductor layer after the growth becomes flat, the fabricating method of the semiconductor device after the growth of the semiconductor layer can be made to a stable one. Further, by that the composition of the semiconductor layer can be controlled independently for the respective partial regions, the degree of freedom in designing the semiconductor device can be largely enhanced.

According to a third aspect of the present invention, in the above-described fabricating method of a semiconductor device, the process of growing the III-V group compound semiconductor layer comprises growing the III-V group compound semiconductor layer on the surface of the semiconductor substrate having a first partial region having a first temperature and a second partial region adjacent to the first partial region having a second temperature lower than the first temperature, and after the growth of the semiconductor layer, forming an optical waveguide extending over the first partial region and the second partial region, and forming a light modulator having the optical waveguide in the first partial region and a laser element having the optical waveguide in the second partial region. Therefore, the compositions of the semiconductor layers in the laser element formation region and the light modulator formation region can be precisely controlled and the energy difference between the bottom level in the conduction band and the bottom level in the valence band of the quantum well of the active layer in the light modulator can be made to quite close to that in the laser element, whereby the light absorption efficiency of the light modulator for the laser light oscillating at the laser element can be enhanced.

According to a fourth aspect of the present invention, in the above-described fabricating method of a semiconductor device, the semiconductor substrate is an n type InP substrate, and the growth of the semiconductor layer forming the light waveguide comprises successively growing an n type InP cladding layer, an active layer, a p type InP cladding layer, and a p type InGaAs contact layer. Therefore, the compositions of the semiconductor layers in the laser element formation region and the light modulator formation region can be precisely controlled and the light absorption efficiency of the light modulator for the laser light oscillating at the laser element can be enhanced and when the laser light from the laser element is modulated by this modulator, a good light attenuation ratio is obtained. In addition, since the surface of the semiconductor layer after the growth becomes flat over the laser element formation region and the light modulator formation region, the process for fabricating a semiconductor device after the growth of the semiconductor layer can be made to stable. In addition, since the compositions of the semiconductor layers can be controlled in the laser element formation region and the light modulator formation region independently, respectively, the degree of freedom in designing the semiconductor device can be enhanced.

According to a fifth aspect of the present invention, in the above-described fabricating method of a semiconductor device, the semiconductor substrate is an n type InP substrate, and the growth of the semiconductor layer forming the light waveguide comprises successively growing an n type InP cladding layer, an n type InGaAsP guide layer, an active layer, an InGaAsP guide layer, a p type InP cladding layer, and a p type InGaAs contact layer. Therefore, the compositions of the semiconductor layers in the laser element formation region and the light modulator formation region can be precisely controlled and the light absorption efficiency of the light modulator for the laser light oscillating at the laser element can be enhanced and when the laser light from the laser element is modulated by this modulator, a good light attenuation ratio is obtained. In addition, since the surface of the semiconductor layer after the growth becomes flat over the laser element formation region and the light modulator formation region, the process for fabricating a semiconductor device after the growth of the semiconductor layer can be made to stable. In addition, since the compositions of the semiconductor layers can be controlled in the laser element formation region and the light modulator formation region independently, respectively, the degree of freedom in designing the semiconductor device can be enhanced.

According to an sixth aspect of the present invention, in the above-described fabricating method, the reflectivity to the thermal radiation for heating the substrate on the rear surface of the semiconductor substrate is made to different dependent on partial regions of the rear surface of the semiconductor substrate, thereby making each of partial regions of the surface of the semiconductor substrate corresponding to partial regions of the rear surface of the semiconductor substrate having a higher reflectivity have a lower temperature. Therefore, the partial region having the low reflectivity is easy to absorb the heat radiation, and the partial region of the surface of the semiconductor substrate corresponding to the partial region of the rear surface of the semiconductor substrate having lower reflectivity becomes to have a higher temperature.

According to a seventh aspect of the present invention, in the above-described fabricating method of a semiconductor device, the rear surface of the semiconductor substrate includes a first partial region having a mirror surface and a second partial region having a fine surface including fine concavo-convex, disposed adjacent the first partial region; and the reflectivity to the thermal radiation for heating the substrate in the first region of the rear surface of the semiconductor substrate is made to higher in the second partial region than in the first partial region. Therefore, the first partial region of the rear surface of the semiconductor substrate is easier to absorb the heat radiation than the second partial region, and the partial region of the surface of the semiconductor substrate corresponding to the first partial region of the rear surface of the semiconductor substrate becomes to have a higher temperature than the partial region of the surface of the semiconductor substrate corresponding to the second partial region.

According to an eighth aspect of the present invention, in the above-described fabricating method of a semiconductor device, a reflective film is formed in a partial region of the rear surface of the semiconductor substrate so as to make the reflectivity to the thermal radiation for heating the substrate in the partial region of the rear surface of the semiconductor substrate higher than those in partial regions except the first-defined partial region. Therefore, the partial regions other than that partial region where the reflective film is formed becomes easy to absorb the thermal radiation than that partial region, and a partial region of the front surface of the semiconductor substrate corresponding to that partial region of the rear surface of the semiconductor substrate where the reflective film is formed becomes to have a lower temperature than partial regions other than that partial region of the front surface.

According to a ninth aspect of the present invention, in the above described fabricating method of a semiconductor device, an anti-reflective film is formed in a partial region of the rear surface of the semiconductor substrate which is finished to be a mirror surface so as to make the reflectivity to the thermal radiation for heating the substrate in partial regions except the first-defined partial region of the rear surface of the semiconductor substrate higher than that in the first-defined partial region. Therefore, that partial region where the anti-reflective film is formed becomes easy to absorb the thermal radiation than the partial regions other than that partial region, and the partial region of the surface of the semiconductor substrate corresponding to the partial region of the rear surface of the semiconductor substrate where the anti-reflective film is formed becomes to have a higher temperature than the partial regions other than that partial region.

According to a tenth aspect of the present invention, in the above-described fabricating method of a semiconductor device, the semiconductor substrate is supported by a susceptor having a hollow for receiving the semiconductor substrate therein, the bottom surface of the hollow of the susceptor just in contact with the rear surface of the semiconductor substrate. Therefore, the semiconductor substrate is heated by the thermal radiation from the susceptor and the thermal conduction due to contacting the susceptor, and since the reflectivity to the thermal radiation for heating the substrate at the rear surface of the semiconductor substrate is different dependent on the partial region, the thermal radiation from the susceptor is easy to be absorbed by the partial region having a lower reflectivity, thereby as the partial region of the surface of the semiconductor substrate corresponding to the partial region of the rear surface of the semiconductor substrate having a lower reflectivity, the temperature thereof becomes higher.

According to a eleventh aspect of the present invention, in the above-described fabricating method of a semiconductor device, the semiconductor substrate is supported by a susceptor having a two-stage hollow for receiving and supporting the semiconductor substrate therein with providing space between the rear surface of the semiconductor substrate and the bottom surface of the two-stage hollow of the susceptor. Therefore, the semiconductor substrate is mainly heated by the thermal radiation from the susceptor, and since the reflectivity to the thermal radiation for heating the substrate at the rear surface of the semiconductor substrate is different dependent on the partial region, the thermal radiation from the susceptor is easy to be absorbed by the partial region having a lower reflectivity, thereby as the partial region of the surface of the semiconductor substrate corresponding to the partial region of the rear surface of the semiconductor substrate having a lower reflectivity, the temperature thereof becomes higher. Meanwhile, at the second concave region in the substrate supporting concave part of the susceptor, there arises no heat conduction due to contacting the rear surface of the semiconductor substrate to the surface of the susceptor, and the temperature difference due to a difference in the reflectivity to the thermal radiation of the rear surface of the semiconductor substrate becomes larger than that in the case where the susceptor in the fabricating method of a semiconductor device of the eleventh aspect is employed.

According to a twelfth aspect of the present invention, in the above-described fabricating method of a semiconductor device, a heat conductive film comprising a material having a high heat conductivity is formed at a partial region of the rear surface of the semiconductor substrate, the semiconductor substrate is supported by a susceptor and heated by thermal conduction from the susceptor, the rear surface of the semiconductor substrate is in contact with the surface of the susceptor via the thermal conductive film at the partial region, so that the temperature of a partial region of the front surface of the semiconductor substrate corresponding to the partial region of the rear surface of the semiconductor substrate is made to higher than the temperature of a partial region of the semiconductor substrate, which partial region is a portion other than the partial region of the front surface of the semiconductor substrate. Therefore, the flow of heat due to heat conduction from the susceptor becomes larger in the partial region where the heat conductive film is formed than that in the partial region other than that partial region, thereby the partial region of the surface of the semiconductor substrate corresponding to the partial region of the rear surface of the semiconductor substrate where the heat conductive film is formed becomes to have a higher temperature than the partial region other than that partial region of the surface of the semiconductor substrate.

According to a thirteenth aspect of the present invention, in the above-described method of a semiconductor device, the semiconductor substrate comprises a first partial region which is thick and a second partial region which is thin, the semiconductor substrate is supported by a susceptor and is heated by the heat conduction from the susceptor, the first partial region of the rear surface of the semiconductor substrate is in contact with the surface of the susceptor and the second partial region of the rear surface of the semiconductor substrate is not in direct contact with the surface of the susceptor, and the temperature of the first partial region of the surface of the semiconductor substrate is higher than the temperature of the second partial region of the surface of the semiconductor substrate. Therefore, while the second partial region is heated only by the heat radiation from the susceptor, the first partial region is heated also by the heat conduction that is generated by the contact with the susceptor as well as by the heat radiation, whereby the temperature of the first partial region of the surface of the semiconductor substrate can be made to higher than the temperature of the second partial region.

According to an fourteenth aspect of the present invention, in the above-described fabricating method of a semiconductor device, the rear surface of the semiconductor substrate comprises a first partial region having a flat surface and a second partial region having a fine concavo-convex plane, the reflectivity to the thermal radiation of the rear surface of the semiconductor substrate is the same through the first partial region and the second partial region, the semiconductor substrate is supported by a susceptor with the entire rear surface of the semiconductor substrate being in contact with the surface of the susceptor; the heating of the semiconductor substrate is carried out by the thermal conduction and thermal radiation from the susceptor, and the temperature of a partial region of the semiconductor substrate in the front surface of the semiconductor substrate, corresponding to the first partial region of the rear surface of the semiconductor substrate, is made to higher than the temperature of a partial region of the semiconductor substrate in the front surface of the semiconductor substrate, corresponding to the second partial region of the rear surface of the semiconductor substrate. Therefore, while the heating of the substrate by the heat radiation from the susceptor is carried out similarly on the entire surface of the rear surface of the substrate, since the contact area per unit area of the rear surface of the semiconductor substrate with the susceptor surface is larger in the first partial area than in the second partial area, the flow of heat per unit area flowing through the substrate is larger in the first partial area in the second partial area. Accordingly, the temperature of the partial region of the surface of the semiconductor substrate corresponding to the first partial area of the rear surface of the semiconductor substrate can be made to higher than the partial area of the surface of the semiconductor substrate corresponding to the second partial area of the rear surface of the semiconductor substrate.

According to a fifteenth aspect of the present invention, in the above-described semiconductor substrate, the semiconductor substrate is supported by a susceptor having a hollow at a region on its surface smaller than the semiconductor substrate and is heated by the thermal conduction and thermal radiation from the susceptor, the rear surface of the semiconductor substrate is in contact with the surface of the susceptor so as to cover the hollow and not in contact with the surface of the susceptor in the hollow, the temperature of the front surface of the semiconductor substrate is made to higher, in a partial region of the front surface of the semiconductor substrate, which partial region corresponds to the partial region of the rear surface of the semiconductor substrate, which is in contact with the surface of the susceptor other than the hollow portion, than that in a partial region of the front surface of the semiconductor substrate, which partial region corresponds to the hollow portion of the susceptor. Therefore, while in the region of the rear surface of the semiconductor substrate which corresponds to the concave part of the susceptor, the substrate is heated only by the heat radiation from the susceptor, in the region of the rear surface of the semiconductor substrate corresponding to the region other than the concave part, the substrate is heated by the heat conduction due to contacting the susceptor, and the temperature of the surface of the semiconductor substrate can be made to higher in the partial region corresponding to the partial region of the rear surface of the semiconductor substrate contacting the surface of the susceptor other than the convex part than that in the partial region corresponding to the convex part of the susceptor.

According to a sixteenth aspect of the present invention, in the above-described fabricating method of a semiconductor device, the semiconductor substrate is supported by a susceptor and is heated by the thermal conduction and thermal radiation from the susceptor, the entire rear surface of the semiconductor substrate is in contact with the surface of the susceptor, the susceptor comprising a first portion comprising a first material and a second portion comprising a second material having a higher conductivity than that of the first material, the temperature of a partial region of the front surface of the semiconductor substrate, which partial region corresponds to the first portion of the susceptor, is made to higher than that of a partial region of the front surface of the semiconductor substrate, which partial region corresponds to the second portion of the susceptor. Therefore, the flow of heat to the semiconductor substrate becomes larger at the second portion than that at the first portion of the susceptor and the temperature of the partial region corresponding to the first portion of the susceptor in the surface of the semiconductor substrate can be made to higher than that at the partial region corresponding to the second portion of the susceptor.

According to a seventeenth aspect of the present invention, in the above-described fabricating method of a semiconductor device, a portion of the semiconductor substrate is irradiated with the argon laser light or the He-Ne laser light so as to raise the temperature of the partial region that is irradiated with the light relative to the temperature of the other partial region. Therefore, the partial region of the semiconductor substrate irradiated with the light is heated by the light and the temperature of the partial region can be made to higher than the temperature of the other partial region.

According to a eighteenth aspect of the present invention, in the above-described fabricating method of a semiconductor device, the semiconductor substrate is supported by the susceptor with its periphery in contact with the susceptor and with its portions other than the periphery not in contact with the susceptor, and the semiconductor substrate is heated by the thermal radiation from the side of the rear surface of the semiconductor substrate and the argon laser light or the He-Ne laser light irradiation from the side of the rear surface of the semiconductor substrate to a portion of the semiconductor substrate, whereby the temperature of the partial region of the semiconductor substrate which is irradiated with the light is made to higher than the temperature of a partial region of the semiconductor substrate other than the partial region. Therefore, the semiconductor substrate of the partial region which is irradiated with the light is heated by the thermal radiation as well as the emitted light, whereby the temperature of the partial region of the semiconductor substrate irradiated with the light can be made to higher than the temperature of a partial region of the semiconductor substrate other than the partial region.

According to a nineteenth aspect of the present invention, in the above-described fabricating method of a semiconductor device, the growth of the III-V group compound semiconductor layer is carried out employing molecular beam epitaxy, gas source beam epitaxy, or a chemical beam epitaxy, and a portion of the semiconductor substrate is irradiated with an electron beam so as to raise the temperature of the partial region which is irradiated with the electron beam relative to a partial region other than that partial region. Therefore, the semiconductor substrate of the partial region which is irradiated with the electron beam is heated by this electron beam, and the temperature of this partial region can be made to higher than the temperature of the other portion.

According to a twentieth aspect of the present invention, in the above-described fabricating method, the semiconductor substrate is supported by the susceptor with its periphery in contact with the susceptor and with its portions other than the periphery not in contact with the susceptor, and the semiconductor substrate is heated by the thermal radiation from the side of the rear surface of the semiconductor substrate and the irradiation of electron beam from the side of the rear surface of the semiconductor substrate to a portion of the semiconductor substrate. Therefore, the temperature of the partial region of the semiconductor substrate which is irradiated with electron beam is made to higher than the temperature of a partial region of the semiconductor substrate other than the partial region.

According to a twenty-first aspect of the present invention, in the above-described fabricating method, the process of growing the optical waveguide layer comprises a first growth process of growing a first semiconductor layer including the active layer as an uppermost layer on the semiconductor substrate, and growing a grating layer comprising a semiconductor forming a diffraction grating on the first semiconductor layer, and a second growth process of growing a second semiconductor layer including a cladding layer as its uppermost layer on the entire surface and burying the diffraction grating; and further comprises: a process of, after the first growth process and before the second growth process, after coating resist on the grating layer, forming a periodic lattice shaped resist pattern at a region where the laser element is to be formed by interference exposure method, and etching the lattice layer using the resist as a mask, thereafter, removing the resist and forming a diffraction grating comprising the grating layer remained below the resist pattern. Therefore, the laser oscillation in the semiconductor laser element can be made to a stable single mode oscillation.

According to a twenty-second aspect of the present invention, a semiconductor device including a laser element and a light modulator both comprising III-V group compound semiconductor and formed on a same substrate, comprises: the laser element and the light modulator includes an active layer; the composition of the semiconductor forming the active layer of the laser element is different from the composition of the semiconductor forming the active layer of the light modulator. Therefore, the compositions of the active layer in the laser element and the light modulator can be controlled with high precision. Further, the compositions of the semiconductor constituting the active layer can be controlled in the laser element and the light modulator independently, and the degree of freedom in designing the semiconductor device can be enhanced.

According to a twenty-third aspect of the present invention, in the above-described semiconductor device, the active layer of the laser element and the active layer of the light modulator include InGaAsP or InGaAs. Therefore, the compositions of InGaAsP or InGaAs included in the active layer in the laser element and the light modulator can be precisely controlled. In addition, the compositions of the InGaAsP or InGaAs included in the active layer can be controlled independently and the degree of freedom in designing the semiconductor device can be enhanced.

According to a twenty-fourth aspect of the present invention, in the above-described semiconductor device, each of the laser element and the light modulator includes optical waveguides laminating an n type InP cladding layer, the active layer, a p type InP cladding layer, and a p type InGaAs contact layer, successively. Therefore, the compositions of InGaAsP or InGaAs included in the active layer in the laser element and the light modulator can be precisely controlled. In addition, the compositions of the InGaAsP or InGaAs included in the active layer can be controlled independently and the degree of freedom in designing the semiconductor device can be enhanced.

According to a twenty-fifth aspect of the present invention, in the above-described semiconductor device, each of the laser element and the light modulator includes optical waveguides laminating the n type InP cladding layer, an n type GaInAsP guide layer, the active layer, a GaInAsP guide layer, the p type InP cladding layer, and a p type InGaAs contact layer. Therefore, the compositions of InGaAsP or InGaAs included in the active layer in the laser element and the light modulator can be precisely controlled. In addition, the compositions of the InGaAsP or InGaAs included in the active layer can be controlled independently and the degree of freedom in designing the semiconductor device can be enhanced.

According to a twenty-sixth aspect of the present invention, in the above-described semiconductor device, the wavelength of the laser light oscillating in the laser element is 1.55 µm, and the maximum wavelength of the light absorbed in a state where no bias voltage is applied in the light modulator is 1.49 µm. Therefore, the compositions of InGaAsP or InGaAs included in the active layer in the laser element and the light modulator can be precisely controlled. In addition, the compositions of the InGaAsP or InGaAs included in the active layer can be controlled independently and the degree of freedom in designing the semiconductor device can be enhanced.

According to a twenty-seventh aspect of the present invention, in the above-described semiconductor device, a diffraction grating is formed on the active layer of a laser element. Therefore, the laser oscillation in the laser element can be made to a stable single mode oscillation.

### BRIEF DESCRIPTION OF THE DRAWINGS

Figure 1 is a cross-sectional view illustrating a method of fabricating a semiconductor device according to a first embodiment of the present invention.

Figure 2 is a diagram illustrating growth temperature dependency of the composition (changing rate of lattice constant) and PL wavelength of InGaAsP grown by MOCVD.

Figure 3 is a cross-sectional view illustrating a semiconductor device according to a first embodiment of the present invention.

Figure 4 is a cross-sectional view illustrating a method of fabricating a semiconductor device according to a second embodiment of the present invention.

Figure 5 is a cross-sectional view illustrating a method of fabricating a semiconductor device according to a third embodiment of the present invention.

Figure 6 is a cross-sectional view illustrating a method of fabricating a semiconductor device according to a fourth embodiment of the present invention.

Figure 7 is a cross-sectional view illustrating a method of fabricating a semiconductor device according to a fifth embodiment of the present invention.

Figure 8 is a cross-sectional view illustrating a method of fabricating a semiconductor device according to a sixth embodiment of the present invention.

Figure 9 is a cross-sectional view illustrating a method of fabricating a semiconductor device according to a seventh embodiment of the present invention.

Figure 10 is a cross-sectional view illustrating a method of fabricating a semiconductor device according to an eighth embodiment of the present invention.

Figure 11 is a cross-sectional view illustrating a method of fabricating a semiconductor device according to a ninth embodiment of the present invention.

Figure 12 is a cross-sectional view illustrating a method of fabricating a semiconductor device according to a embodiment of the present invention.

Figure 13 is a cross-sectional view illustrating a method of fabricating a semiconductor device according to a eleventh embodiment of the present invention.

Figure 14 is a cross-sectional view illustrating a method of fabricating a semiconductor device according to a twelfth embodiment of the present invention.

Figure 15 is a cross-sectional view illustrating a method of fabricating a semiconductor device according to a thirteenth embodiment of the present invention.

Figure 16 is a cross-sectional view illustrating a method of fabricating a semiconductor device according to a fourteenth embodiment of the present invention.

Figure 17(a) is a plan view illustrating a method of fabricating a semiconductor device in which a laser element and a light modulator are integrated on a same substrate and figure 17(b) is a cross-sectional view according to the prior art.

### DETAILED DESCRIPTION OF THE PREFERRED EMBODIMENTS

### Embodiment 1.

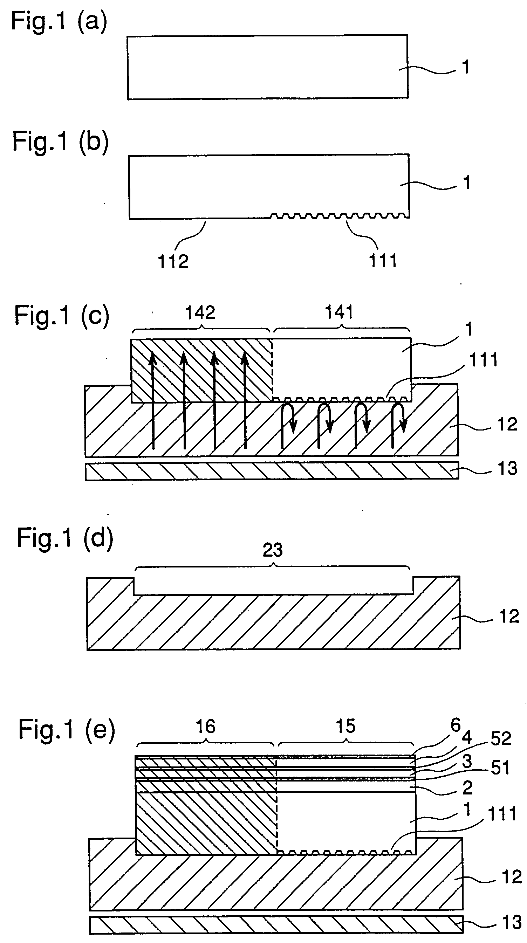

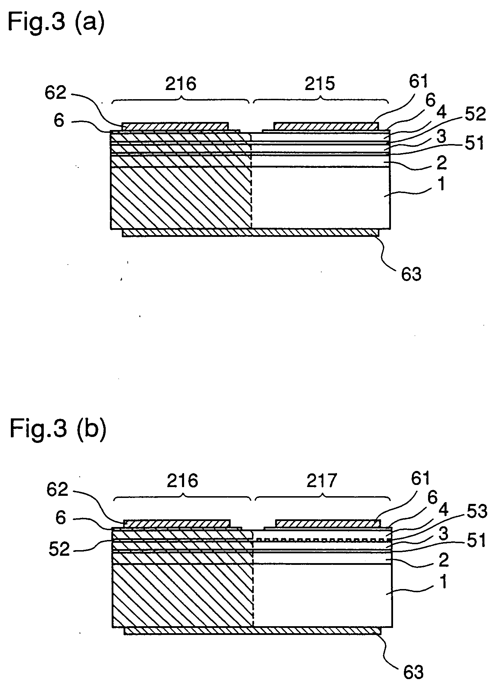

Figure 1 is a cross-sectional view illustrating a method for fabricating a semiconductor device in which a light modulator and a laser element are integrated on a same substrate according to a first embodiment of the present invention, and figure 3 is a cross-sectional view illustrating a semiconductor device that is fabricated employing this fabricating method.

Initially, the method of fabricating the semiconductor device of this first embodiment will be described.

First, in the step of figure 1(a), an n type InP substrate 1 is prepared, and the rear surface of the substrate 1 is finished so that a portion thereof has a surface 111 having fine concavo-convex and another portion has a mirror surface 112. Further, as shown in figure 1(c), the n type InP substrate 1 is mounted on a susceptor 12. A hollow 23 for supporting the substrate in which the substrate is engaged is provided on the surface of the susceptor 12, as shown in figure 1(d). The n type InP substrate 1 is supported by the susceptor 12 with the rear surface of the substrate 1 is in contact with the front surface of the susceptor 12, i.e., the substrate supporting part 28. Meanwhile, as shown in the step of figure 1(c), the susceptor 12 is heated by the heater 13 provided at the rear surface side of the susceptor 12 and the InP substrate 1 is heated by the thermal radiation and thermal conduction from the susceptor 12. However, since the reflectivity against the thermal radiation of the concavo-convex surface 111 of the rear surface of the InP substrate 1 is larger than that of the mirror surface 112, while the thermal radiation from the susceptor 12 represented by arrows in figure 1(c) reach inside the substrate transmitting through the rear surface of the substrate in the mirror surface region 112, a lot of them are reflected by the rear surface of the substrate in the concavo-convex surface region 111. In addition, the thermal conduction from the susceptor 12 advances into the substrate passing through the contact surface between the susceptor and the InP substrate, the area per unit area which is actually in direct contact with the surface of the susceptor 12, in the rear surface of the InP substrate 1 is larger in the mirror surface region 112 than that in the concavo-convex surface region 111, therefore, the thermal amount which the InP substrate receives by the thermal conduction is larger in the partial region of the InP substrate at the side of the mirror surface region 112 than in the partial region of the substrate at the side of the concavo-convex region 111. Accordingly, the InP substrate 1 becomes to have a temperature higher at the portion 142 (high temperature portion) at side of the mirror surface region than at the portion 141 (low temperature portion) at the side of the concavo-convex surface region 111. While heating the n type InP substrate 11 via the susceptor 12, in the step of figure 1(e), the n type InP cladding layer 2, the n type InGaAsP guide layer 51, the multi-quantum well active layer 3, the InGaAsP guide layer 52, the p type InP cladding layer 4, and the p type InGaAs contact layer 6 are successively grown on the surface of the substrate by MOCVD. These grown layers are grown on the two regions having different temperatures on the substrate. Here, the well layer and the barrier layer both comprise InGaAsP, and the compositions of InGaAsP of the respective layers are those producing a larger band gap in the barrier layer than in the well layer.

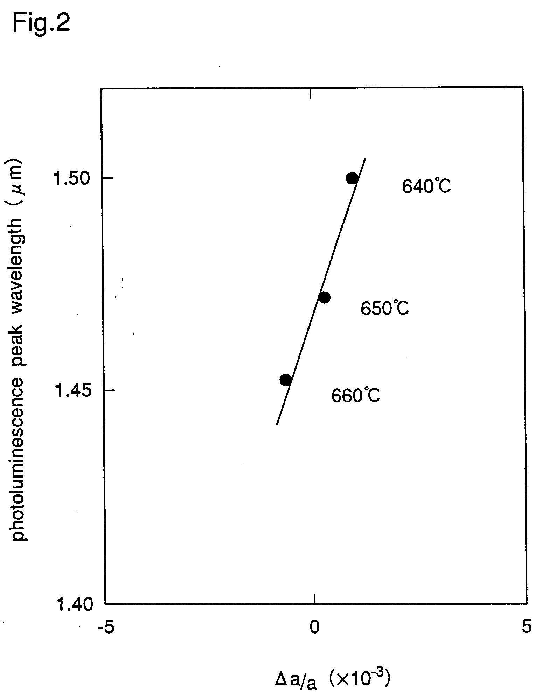

When GaInAsP constituting the active layer of the long wavelength semiconductor laser is grown by MOCVD, there is a growth temperature dependence in the peak wavelength in photoluminescence spectrum which corresponds to its energy band gap. This is the reason that the dissociation efficiency of V group atoms changes dependent on the growth temperature, thereby the composition of GaInAsP changes. The temperature dependency of the PL wavelength is shown in figure 2. Here, in figure 2, a designates a lattice constant and the ordinate Δa/a is a change rate of the lattice constant. The change of the composition corresponds to the change of the lattice constant a. From this figure, it can be seen that the composition changes dependent on the growth temperature, and the PL wavelength changes in accordance with the change of the composition. In the vicinity of the 650°C which is a usual growth temperature, as the growth temperature is high, the PL wavelength is shortened. In other words, the energy band gap of the GaInAsP becomes large. In this temperature range, there is a change in the energy band gap corresponding to the wavelength change 0.05 µm with the temperature difference of 20 °C. Accordingly, in order to make the wavelength of light corresponding to the energy difference between the bottom band of the conduction band and the bottom level of the valence band in the well layer of the multi-quantum well active layer of the modulator (hereinafter simply referred to as wavelength of active layer) is made to 4.9 µm and the wavelength of the active layer of the laser element 1.55 µm, the temperature of the high temperature part 142 may be made to higher than the temperature of the low temperature part 141 by 20 ∼ 25 °C. Thereby, the active layer of the modulator can be grown on the high temperature region 142, and the active layer of the laser element can be grown on the active layer of the laser element. In figure 1(e), a portion becoming the laser element is illustrated as laser element part 15, and a portion becoming the modulator is illustrated as the modulator part 16.

After a semiconductor layer including the active layer 3 on an InP substrate in this way, the stripe shaped light waveguide comprising these semiconductor layers is formed over the laser element portion 15 and the light modulator part 16. Then, if necessary, a diffraction grating may be formed at the waveguide. Next, as shown in figure 3(a), after the p type InGaAs contact layer 6 at a boundary portion between the laser element part 15 and the optical modulator part 16 is removed by etching, the rear surface of the InP substrate 1 is deleted and polished, further, a laser element front surface electrode 61 is formed on the surface of the contact layer 6 of the laser element part 15, and a rear surface electrode 63 is formed at the rear surface of the InP substrate 1. Here, the surface electrodes 61, 62 comprise metal that can be in ohmic contact with the p type InGaAs contact layer 6, and the rear surface electrode 63 comprise metal that can be in ohmic contact with the p type InGaAs contact layer 6.

Thereby, the laser element 215 and the light modulator 216 are integrated on the same substrate, and the semiconductor device shown in figure 3(a), which has the active layer 3 continuous over the laser element and the light modulator can be obtained. In this semiconductor laser, the laser light of wavelength of 1.55 µm oscillated at the laser element 215 is incident to the active layer of the light modulator 216 through the waveguide including the active layer 3. When the bias voltage applied to the light modulator is zero, the laser light transmits the active layer of the modulator and when the bias voltage of a reverse bias voltage, the laser light is absorbed by the active layer of the modulator. Accordingly, the laser light emitted from the laser element which is operated by dc can be modulated by changing the bias voltage applied to the modulator.

In the laser element, a diffraction grating may be formed on the active layer 3. Such laser is called DFB (distributed feedback) laser, and it is possible to realize a stable single mode oscillation. This diffraction grating can be formed as follows. Particularly, first of all, while growing the semiconductor layer shown in figure 1(e), after the InGaAsP guide layer 52 is grown, resist is plated on the layer and interference exposure method is performed to remain periodic resist pattern on the laser element part 15. Next, using the resist as a mask, the InGaAsP layer is etched and thereafter, the diffraction grating comprising the InGaAsP guide layer is formed only on the laser element part 15. In addition, after the resist is removed, the p type InP cladding layer 4 and the p type InGaAs contact layer 6 is grown by the MOCVD method. Thereby, the diffraction grating is buried in the p type InP cladding layer 4. The light waveguide forming process, the element separating process between the laser element and the light modulator, and the electrode forming process are the same as those in the fabricating method which does not form the above-described diffraction grating. Thereby, the semiconductor device in which the DFB laser device 217 provided with the diffraction grating 53 comprising InGaAsP and the light modulator 216 are integrated on a same substrate and having an active layer 3 which is running over the DFB laser element and the light modulator as shown in figure 3(b) is obtained.

In this first embodiment, the rear surface of the InP substrate 1 comprises the region of the fine concavo-convex 111 and the region of the mirror surface 112, therefore, the flow of heat to the InP substrate from the susceptor 12 becomes large in the mirror surface region in the concavo-convex surface region. Thereby, the temperature of a portion at the side of the mirror surface region (high temperature portion 42) becomes higher than that of the portion of the side of the concavo-convex surface region of the InP substrate, and the compositions of the semiconductor layers grown on these two portions become different and the wavelength of a portion that is grown on the low temperature portion 141 becomes longer than the wavelength of the portion that is grown on the high temperature portion 142. Accordingly, by forming a laser element by a semiconductor layer grown on the low temperature portion and forming a light modulator by a semiconductor layer grown on the high temperature portion, a laser element and light modulator integrated on a same substrate and having an active layer 3 continuous over the both regions can be formed. Meanwhile, by controlling the growth temperature, the InGaAsP composition of the active layer can be controlled with high precision, and the energy difference between the bottom level of the conduction band of the quantum well of the active layer in the light modulator and the bottom level of the valence band of the quantum well can be made to quite close to that in the element, thereby the light absorbing coefficient of the light modulator for the light oscillated in the laser element can be enhanced. Accordingly, when the laser light from the laser element is modulated, good light attenuation ratio is obtained. Actually, in the light modulator fabricated as described above, a good attenuation ratio (on/off ratio) of 10 dB is obtained.

In addition, in the first embodiment, the growth method used in the prior art fabricating method described above is not used and a semiconductor layer is grown on the entire surface of the InP substrate, the surface of the semiconductor layer after the growth becomes flat and no step is produced between the laser element region and the light modulator region. Accordingly, the fabricating method after growing the semiconductor layer can be made to stable one.

Further, in the first embodiment, by controlling the growth temperatures of the respective growths, the composition of the InGaAsP forming the active layer can be controlled in the laser element portion and the light modulator region independently, respectively, thereby wavelength of the oscillating light of the laser element and the wavelength of the absorption light of the light modulator can be controlled independently, whereby the degree of freedom of design of the semiconductor device can be largely enhanced.

Besides, the active layer 3 may be not the multi-quantum well layer but a bulk active layer comprising InGaAsP or InGaAs.

In addition, the n type InGaAsP guide layer 51 and the InGaAsP guide layer 52 may be not provided if not required.

Furthermore, the fabricating method of a semiconductor device of this first embodiment may be applied not only to a case where MOCVD is used, but also to a case where MBE (molecular beam epitaxy), gas source MBE, or CBE (chemical beam epitaxy) is used.

### Embodiment 2.

A description is given of a second embodiment of the present invention.

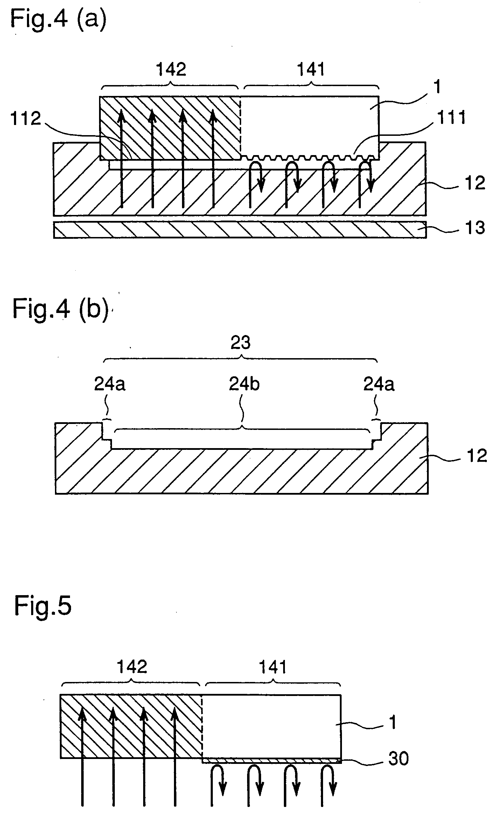

Figure 4 is a cross-sectional view illustrating a fabricating method of a semiconductor device comprising a light modulator and a laser element integrated on a same substrate according to a second embodiment of the present invention. In this second embodiment, the substrate supporting convex part 23 provided at the surface of the susceptor 12 comprises a first concave part 24a for supporting the substrate in contact with the periphery of the rear surface of the semiconductor substrate and a second concave part 24b formed inside the first concave part 24a, and the surface of the second concave part 24b confronts the rear surface of the semiconductor substrate via the space. The InP substrate 1 is supported by the susceptor 12 and is heated as shown in figure 4(a). Here, the rear surface of the InP substrate 1 has a portion which becomes the surface 111 having concavo-convex and the other portion thereof makes the mirror surface 112. On the InP substrate 1 heated as described above, using the process the same as that shown in the first embodiment, the semiconductor layer is grown and a laser element and a light modulator is formed.

In this second embodiment, since a larger portion of the rear surface of the substrate 1 is not in contact with the susceptor 12, in the flow of heat from the susceptor 12 to the substrate 1, the heat radiation from the second concave part 24b confronting to the rear surface of the substrate becomes dominant and, since the reflectivity against the heat radiation is smaller in the mirror surface 112 that at the concavo-convex surface 111, the temperature at a portion corresponding to the mirror surface 112 becomes higher than the temperature of a portion corresponding to the concavo-convex surface 111 becomes higher. In the above-described first embodiment, the heat conduction contributes to the flow of the heat other than the heat radiation, the difference between the thermal flow due to the heat conduction between the concavo-convex surface and the mirror surface is smaller than the difference between the thermal flow due to the thermal radiation between the both. Accordingly, in this second embodiment, the temperature difference between the two portions of the substrate can be made to large. Particularly, when the temperature difference cannot be obtained sufficiently between the laser element part and the modulator part in the method of the first embodiment, by using the susceptor which has the substrate supporting concave part 23 including the first concave part 24a and the second concave part 24b of this second embodiment, it is possible to provide the temperature difference effectively. By making the temperature of the high temperature portion 142 higher than the temperature of the low temperature portion 141 by 20 ∼ 25°C, it is possible to grow the active layer of the light modulator of wavelength of 1.49 µm at the high temperature portion 142, and grow the active layer of the laser element of wavelength of 1.5 µm at the low temperature portion 141.

Also in this second embodiment, as in the first embodiment, the compositions of the semiconductor layers grown on the two portions of the InP substrate 1 can be made to different, and it is possible to form the laser element from the semiconductor layer grown on the low temperature part and the light modulator from the semiconductor layer grown on the high temperature part. Meanwhile, the composition of the InGaAsP of the active layer can be controlled with high precision and when the laser light from the laser element is modulated in the modulator, a good light attenuation ratio is obtained. Actually, in the optical modulator which is fabricated by using the method of the second embodiment, a good light attenuation ratio of 10 dB is obtained. In addition, the surface of the grown semiconductor layer becomes flat and the fabricating process thereafter can be made to stable. In addition, by controlling the growth temperature, the composition of the InGaAsP constituting the active layer can be controlled at the laser element part and the light modulator part independently, whereby the degree of freedom in design of the laser device can be enhanced.

Furthermore, the fabricating method of a semiconductor device of this second embodiment may be applied not only to a case where MOCVD is used, but also to a case where MBE, gas source MBE, or CBE is used.

### Embodiment 3.

A description is given of a third embodiment of the present invention.

Figure 5 is a cross-sectional view illustrating a fabricating method of a semiconductor device comprising a light modulator and a laser element integrated on a same substrate according to a third embodiment of the present invention. In this third embodiment, not the finishing of the rear surface of the substrate is changed dependent on the places as in the first and the second embodiments, but a reflective film 30 comprising such as an SiO film of several tens nm thickness is formed at a portion (a portion corresponding to the concavo-convex surface of the first and the second embodiment) of the rear surface of the InP substrate 1. Here, the substrate heating is conducted by using the susceptor similar as in the first and the second embodiments. On the InP substrate 1 heated as above, a semiconductor layer is grown using the similar process shown in the first embodiment, thereby forming a laser element and a light modulator.

In this third embodiment, since the portion of InP substrate 1 where the reflection film 30 is not formed is easy to absorb the heat radiation than the portion where the reflection film 30 is not formed, there arise a temperature difference in the two portions. In other words, the portion where the reflective film 30 is formed becomes the low temperature portion 141 and the portion where no reflective film is formed becomes the high temperature portion 142. By making the temperature of the high temperature portion 142 higher than the temperature of the low temperature portion 141 by 20 ∼ 25 °C, the active layer of the light modulator of wavelength of 1.49 µm is formed at the high temperature portion 142, and the active layer of the laser element of the wavelength of 1.55 µm may be grown at the low temperature portion 141.

Also in this third embodiment, as in the first embodiment, the compositions of the semiconductor layers grown on the two portions of the InP substrate can be made to different from each other, and it is possible to form a laser element from the semiconductor layer grown at the low temperature portion and form a light modulator from the semiconductor layer grown at the high temperature portion. Meanwhile, as in the first embodiment, the composition of InGaAsP can be controlled with high precision, therefore, when the laser light from the laser element is modulated, a good light attenuation ratio is obtained. Actually, in the light modulator fabricated by the method shown in the third embodiment, a light attenuation ratio of 10 dB is obtained. In addition, the surface of the semiconductor layer after the growth becomes flat and the fabrication process thereafter can be made to stable. In addition, by controlling the growth temperature, the composition of InGaAs constituting the active layer can be controlled at the laser element part and the modulator art independently, respectively, whereby the degree of freedom of design of the laser device is enhanced.

Furthermore, the fabricating method of a semiconductor device of this third embodiment may be applied not only to a case where MOCVD is used, but also to a case where MBE, gas source MBE, or CBE is used.

### Embodiment 4.

A description is given of a fourth embodiment of the present invention.

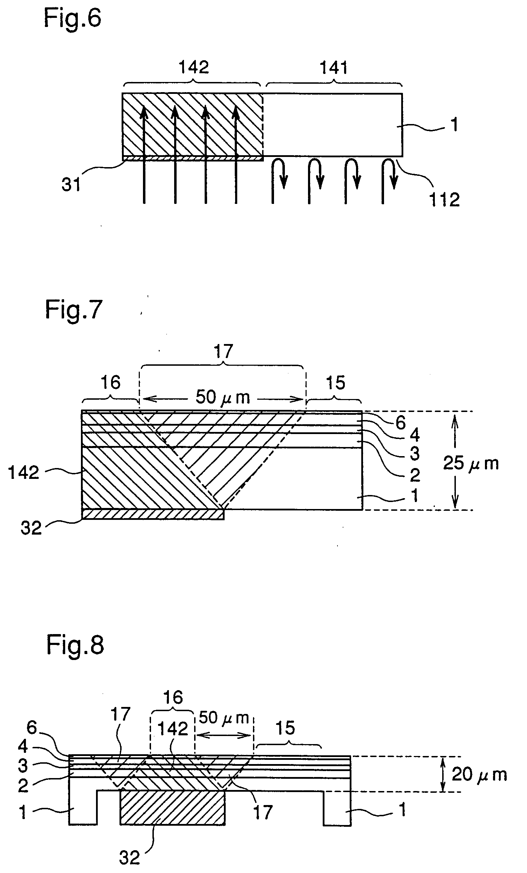

Figure 6 is a cross-sectional view illustrating a fabricating method of a semiconductor device comprising a light modulator and a laser element integrated on a same substrate according to a fourth embodiment of the present invention. In this fourth embodiment, not the finishing of the rear surface of the substrate is changed dependent on the places as in the first and the second embodiments, but the entire surface of the rear surface of the InP substrate 1 is made to a plane finishing as the reflectivity to the thermal radiation is-increased, and an anti-reflective film 31 is formed at a portion (a portion corresponding to the mirror surface of the first and the second embodiments) of the rear surface of the InP substrate 1. Here, the substrate heating is conducted by using the susceptor as in the first embodiment. On the InP substrate 1 heated as above, a semiconductor layer is grown using the similar process shown in the first embodiment, thereby forming a laser element and a light modulator.

In this fourth embodiment, since the portion of the InP substrate 1 where the anti-reflective film 31 is not formed is difficult to absorb the thermal radiation than the portion of the InP substrate 1 where the reflection preventing film 31 is formed, there arises a temperature difference between the two portions. In other words, the portion where the conductive film 31 is formed becomes high temperature portion 142, and the portion where the anti-reflective film is not formed becomes the low temperature portion 141. By making the temperature of the high temperature portion 142 higher than that of the low temperature portion 141 by 20 ∼ 25°C, the active layer of the light modulator of wavelength of 1.49 µm is grown on the high temperature portion 142 and the active layer of the laser element of the wavelength of 1.55 µm is grown at the low temperature portion 141.

Also in this fourth embodiment, as in the first embodiment, the compositions of the semiconductor layers which are grown on the two portions of the InP substrate 1 are made to different, and the laser element is formed by the semiconductor layer grown on the low temperature part and the light modulator part can be formed by the semiconductor layer grown at the high temperature part. Meanwhile, the composition of InGaAsP of the active layer can be controlled with high precision, and when the laser light from the laser element is modulated, a good light attenuation ratio is obtained. Actually, in the optical modulator fabricated using the method illustrated in the fourth embodiment, a good light attenuation ratio is 10 dB is obtained. In addition, when the surface of the semiconductor layer after the growth becomes flat and the fabrication process thereafter can be made to stable. In addition, by controlling the growth temperature, the composition of InGaAs constituting the active layer can be controlled at the laser element part and the light modulator part independently, respectively, and the degree of freedom of design of the laser device is enhanced.

Furthermore, the fabricating method of a semiconductor device of this fourth embodiment may be applied not only to a case where MOCVD is used, but also to a case where MBE, gas source MBE, or CBE is used.

### Embodiment 5.

A description is given of a fifth embodiment of the present invention.

Figure 7 is a cross-sectional view illustrating a fabricating method of a semiconductor device comprising a light modulator and a laser element integrated on a same substrate according to a fifth embodiment of the present invention. In this fifth embodiment, the finishing of the rear surface of the substrate is not changed dependent on the places as in the first and the second embodiments, but a conductive film 32 comprising a material having high conductivity is formed at a portion (a portion corresponding to the mirror surface of the first and the second embodiment) of the rear surface of the InP substrate 1. Here, the substrate heating is conducted by using the susceptor as in the first embodiment. On the InP substrate 1 heated as above, a semiconductor layer is grown using the similar process shown in the first embodiment, thereby forming a laser element and a light modulator. Meanwhile, as shown in figure 7, the semiconductor layer grown on the low temperature portion of the substrate becomes the laser element portion 15 and the semiconductor layer grown on the high temperature portion of the substrate becomes the light modulator portion 16, and since the thermal conduction also occurs not only in the direction vertical to the substrate surface but also in the transverse direction, there is formed a transition region 17 having a temperature intermediate of those of these two portions at the boundary between the high temperature part and the low temperature part. The width of the transition region 17 becomes wide as the thickness of the substrate and the thickness of the semiconductor layer grown on the substrate are thick, since in this embodiment, the total thickness of the InP substrate 1 and the semiconductor layer grown thereon are 25 µm, and the width of the transition region in the transition region becomes about 50 µm as sown in the figure. That distance of this degree does not cause a problem in the operation of the semiconductor device.

In this fifth embodiment, a portion on the InP substrate 1 on which the conductive film 32 is formed has heat quantity of heat which flows into from the susceptor per unit time larger than that at the portion where it is not formed, and there arises a temperature difference between these two portions. That is, the portion where the conductive film 32 is formed becomes high temperature portion, and the portion where the film is not formed becomes the low temperature portion. By making the temperature of the high temperature portion higher than that of the low temperature portion by 20 ∼ 25°C, the active layer of the light modulator of wavelength of 1.49 µm is grown on the high temperature portion and the active layer of the laser element of the wavelength of 1.55 µm is grown at the low temperature portion.

Also in this fifth embodiment, as in the first embodiment, the compositions of the semiconductor layers which are grown on the two portions of the InP substrate 1 can be made to different, and the laser element may be formed from the semiconductor layer grown on the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. Actually, in the optical modulator fabricated using the method illustrated in the fifth embodiment, a good light attenuation ratio is obtained. In addition, the surface of the semiconductor layer after the growth becomes flat and the fabrication process thereafter can be made to stable. In addition, by controlling the growth temperature, the composition of InGaAsP constituting the active layer can be controlled at the laser element part and the modulator part independently, respectively, and the degree of freedom in designing the laser device is enhanced.

Furthermore, the fabricating method of a semiconductor device of this fifth embodiment may be applied not only to a case where MOCVD is used, but also to a case where MBE, gas source MBE, or CBE is used.

### Embodiment 6.

A description is given of a sixth embodiment of the present invention.

Figure 8 is a cross-sectional view illustrating a fabricating method of a semiconductor device comprising a light modulator and a laser element integrated on a same substrate according to a sixth embodiment of the present invention. In this sixth embodiment, a concave part of a depth of about 280 µm is formed at the rear surface of the InP substrate 1 of a thickness of about 300 µm, as shown in figure 8, and a heat conductive film 32 which is thick more than the depth of the concave part is formed. Here, the heating of the substrate is performed by using the susceptor as in the first embodiment. On the InP substrate 1 heated as described above, using the process similar as the process shown in the first embodiment, a semiconductor layer is grown, further a laser element and a light modulator are formed. As shown in figure 8, the semiconductor layer grown on the low temperature portion of the substrate becomes the laser element portion 15 and the semiconductor layer grown on the high temperature portion of the substrate becomes the light modulator portion 16, and the thermal conduction occurs not only in the direction perpendicular to the substrate surface but also in the transverse direction and there exists the transition region 17 having an intermediate temperature between the temperatures of the high temperature portion and the low temperature portion. Since the total thickness of the substrate in the concave part of the InP substrate 1 and the semiconductor layer grown thereon is about 20 µm, the width in the semiconductor layer surface of the transition region becomes about 50 µm as shown in the figure. As described in the fifth embodiments, this does not particularly occur a problem in the operation of the semiconductor device.

In this sixth embodiment, a portion on the InP substrate 1 where the conductive film 32 is formed has heat quantity which flows into the portion from the susceptor per unit time larger than that at the portion where it is not formed, and there arises a temperature difference between these two portions. That is, the portion where the conductive film 32 is formed becomes the high temperature portion 142, and the portion where the film is not formed becomes the low temperature portion. By making the temperature of the high temperature portion higher than that of the low temperature portion by 20 ∼ 25°C, the active layer of the light modulator of wavelength of 1.49 µm is grown on the high temperature portion and the active layer of the laser element of the wavelength of 1.55 µm is grown at the low temperature portion.

Also in this sixth embodiment, unlike the fifth embodiment, the total thickness of the InP substrate 1 is not required to be made to thin, and a thick substrate of about 300 µm may be used and a concave part is only formed at a region of the rear surface of the substrate corresponding to the element formation region, whereby the fabricating process of a semiconductor device becomes a stable one.

Also in this sixth embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. In addition, the surface of the semiconductor layer after the growth becomes flat and the fabrication process thereafter can be made to stable. In addition, by controlling the growth temperature, the composition of InGaAsP constituting the active layer can be controlled at the laser element part and the modulator part independently, respectively, and the degree of freedom in designing the laser device is enhanced.

Furthermore, the fabricating method of a semiconductor device of this sixth embodiment may be applied not only to a case where MOCVD is used, but also to a case where MBE, gas source MBE, or CBE is used.

### Embodiment 7.

A description is given of a seventh embodiment of the present invention.

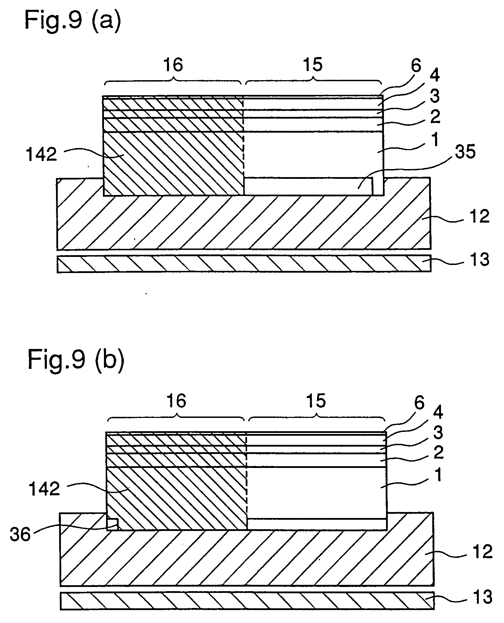

Figure 9 is a cross-sectional view illustrating a fabricating method of a semiconductor device comprising a light modulator and a laser element integrated on a same substrate according to a seventh embodiment of the present invention. In this seventh embodiment, not the finishing of the rear surface of the substrate is changed dependent on the places as in the first and the second embodiments, but a concave part 35 is formed at a portion of the rear surface (a portion corresponding to the concavo-convex surfaces of the first and the second embodiments) of the InP substrate 1 and the rear surface of the substrate is not in contact with the surface of the susceptor in this concave part, or a convex part 36 is formed at a portion of the rear surface of the substrate (a portion corresponding to the mirror surfaces of the first and the second embodiments) and the substrate surface is in contact with the susceptor only in this convex part. Such concave parts and the convex parts of the rear surface of the substrate can be formed by photolithography or etching. Here, the heating of the substrate is conducted by using the susceptor 12 as in the first embodiment. On the InP substrate 1 thus heated, using the similar process as the process in the first embodiment, a semiconductor layer is grown and the laser element and the light modulator are formed.

In this seventh embodiment, at a portion of the rear surface of the InP substrate 1 in contact with the surface of the susceptor, the substrate is heated by both of thermal radiation and thermal conduction, while at a portion of the rear surface of the substrate which is not in the contact with the surface of the susceptor, the substrate is heated by only the heat radiation, therefore, there arises a temperature difference between the two portions. That is, the portion not in contact with the susceptor becomes the low temperature portion and the portion in contact with the susceptor becomes the high temperature portion 142. By making the temperature of the high temperature portion higher than the temperature of tee low temperature portion by 20 ∼ 25 °C, it is possible to grow an active layer of the light modulator of wavelength of 1.49 µm and an active layer of the laser element of wavelength of 1.55 µm at the low temperature portion. The semiconductor layer grown on the low temperature portion of the substrate becomes the laser element portion 15 and the semiconductor layer grown on the high temperature portion of the substrate becomes the light modulator portion 16.

Also in this seventh embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. Actually, in the light modulator fabricated by using the method shown in the seventh embodiment, a good light attenuation ratio of 10 dB is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently respectively, and the degree of freedom in designing the laser device is enhanced.

Furthermore, the fabricating method of a semiconductor device of this seventh embodiment may be applied not only to a case where MOCVD is used, but also to a case where MBE, gas source MBE, or CBE is used.

### Embodiment 8.

A description is given of an eighth embodiment of the present invention.

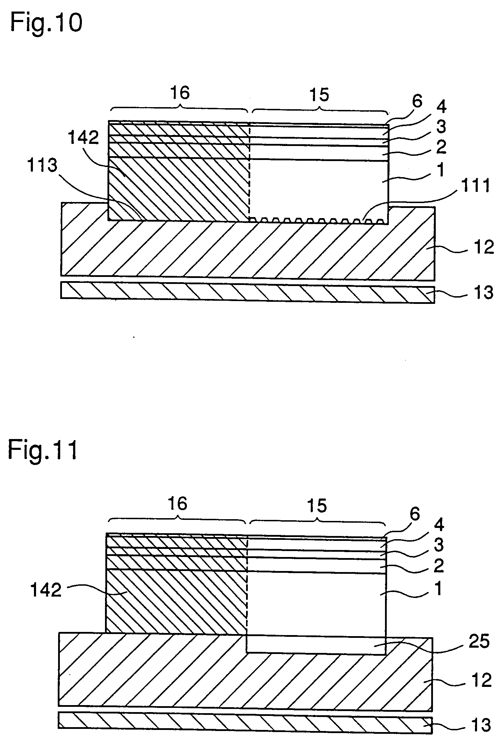

Figure 10 is a cross-sectional view illustrating a fabricating method of a semiconductor device comprising a light modulator and a laser element integrated on a same substrate according to an eighth embodiment of the present invention. In this eighth embodiment, the mirror surface 112 of the rear surface of the substrate 1 in the first embodiment is replaced by the surface 113 which is flat and reflects the thermal radiation to about the same amount as the concave-convex surface 111. This can be realized by making the polishing or the etching used in the finishing of the rear surface of the substrate different ones at the concave-convex plane 111 portion or the flat portion 113 portion. In addition, the concave-convex plane 111 may be formed by the photolithography and etching. Here, the heating of the substrate is performed by using the susceptor as in the first embodiment. On the InP substrate 1 thus heated, using the similar process as the process shown in the first embodiment, the semiconductor layer is grown, and the laser element and the light modulator are formed.

In this eighth embodiment, since the portion of the flat surface 113 has a larger area contacting the surface of the susceptor than the concavo-convex plane 113 of the rear surface of the InP substrate 1, the thermal flow from the susceptor 12 the InP substrate 1 by the thermal conduction is larger at the flat surface portion than that in the concavo-convex surface portion. On the other hand, at these two portions, the reflectivity to the thermal radiation is almost the same as described above, therefore there is no large difference between the thermal flow due to the heat radiation at these portions. Accordingly, there arise a temperature difference at these two portions due to the difference in the thermal conduction. In other words, the substrate portion on the concavo-convex plane 111 becomes the low temperature portion and the substrate portion on the flat surface 113 becomes a high temperature portion 142. By making the temperature of the high temperature portion higher than that of the low temperature portion by 20 ∼ 25 °C at the growth of the active layer, an active layer of the light modulator of wavelength 1.49 µm is grown at the high temperature portion and an active layer of laser element of wavelength of 1.55 µm at the low temperature portion. Therefore, the semiconductor layer grown on the low temperature portion becomes the laser element portion 15 and the semiconductor layer grown on the high temperature portion becomes the light modulator portion 16.

Also in this eighth embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. Actually, in the light modulator fabricated by using the method shown in the eighth embodiment, a good light attenuation ratio of 10 dB is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently, respectively, and the degree of freedom in designing the laser device is enhanced.

Furthermore, the fabricating method of a semiconductor device of this eighth embodiment may be applied not only to a case where MOCVD is used, but also to a case where MBE, gas source MBE, or CBE is used.

### Embodiment 9.

A description is given of a ninth embodiment of the present invention.

Figure 11 is a cross-sectional view illustrating a fabricating method of a semiconductor device comprising a light modulator and a laser element integrated on a same substrate according to a ninth embodiment of the present invention. In this ninth embodiment, the rear surface of the substrate is not changed dependent on the places as in the first to eighth embodiments, a concave part 25 is formed on a portion of the surface of the susceptor (a portion corresponding to the concave-convex surface of the first embodiment), and the rear surface of the substrate is not in contact with the surface of the susceptor. On the InP substrate 1 thus heated, using the similar process as the process in the first embodiment, the semiconductor layer is grown and the laser element and the light modulator are formed.

In this ninth embodiment, at the portion of the rear surface of the InP substrate 1 which is in contact with the surface of the susceptor, the substrate is heated by both of the heat radiation and heat conduction, while at the portion of the rear surface Of the substrate which is not in contact with the surface of the susceptor, it is heated only by the heat radiation and there arises a temperature difference at these two portions. More particularly, the portion not in contact with the susceptor becomes the low temperature portion and the portion in contact with the susceptor becomes a high temperature portion 142. By making the temperature of the high temperature portion than the temperature of the low temperature portion by 20 ∼ 25 °C at the growth of the active layer, an active layer of the light modulator of wavelength 1.49 µm is grown at the high temperature portion and an active layer of laser element of wavelength of 1.55 µm at the low temperature portion. Therefore, the semiconductor layer grown on the low temperature portion becomes the laser element portion 15 and the semiconductor layer grown on the high temperature portion becomes the light modulator portion 16.

Also in this ninth embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently, respectively, and the degree of freedom in designing the laser device is enhanced.

Furthermore, the fabricating method of a semiconductor device of this ninth embodiment may be applied not only to a case where MOCVD is used, but also to a case where MBE, gas source MBE, or CBE is used.

### Embodiment 10.

A description is given of a tenth embodiment of the present invention.

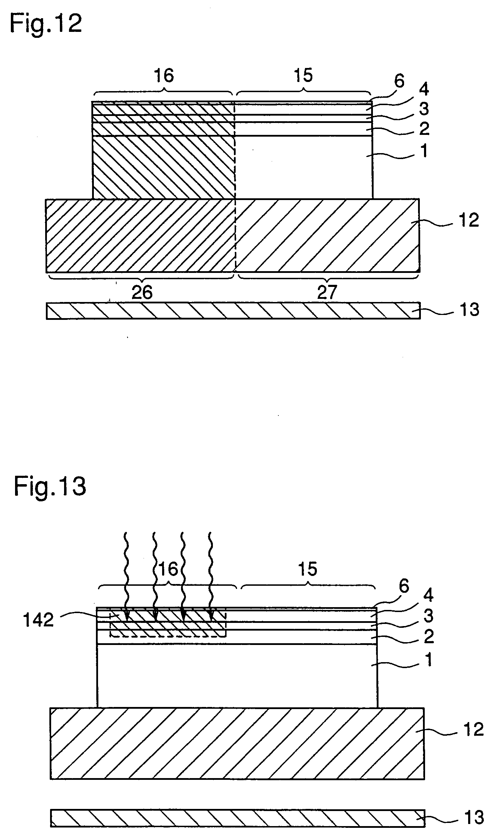

Figure 12 is a cross-sectional view illustrating a fabricating method of a semiconductor device comprising a light modulator and a laser element integrated on a same substrate according to a tenth embodiment of the present invention. In this tenth embodiment, the rear surface of the substrate is not changed dependent on the places as in the first to eighth embodiments, the susceptor comprise a portion 26 comprising a material having high thermal conductivity and a portion 27 comprising a material having a low thermal conductivity. As the high thermal conductivity material Mo, as the low thermal conductivity material C or quartz may be employed.

In this tenth embodiment, the flow of heat from the heater 13 to the InP substrate 1 are different at the two portions of the susceptor, and the portion of the substrate in contact with the portion 26 of the susceptor 1 comprising the high thermal conductivity material become the high temperature portion and the portion of the substrate in contact with the portion 27 of the susceptor comprising the low thermal conductivity material becomes the low temperature portion. By making the temperature of the high temperature portion higher than the temperature of the low temperature portion by 20 ∼ 25 °C at the growth of the active layer, an active layer of the light modulator of wavelength 1.49 µm is grown at the high temperature portion and an active layer of laser element of wavelength of 1.55 µm at the low temperature portion. Therefore, the semiconductor layer grown on the low temperature portion becomes the laser element portion 15 and the semiconductor layer grown on the high temperature portion becomes the light modulator portion 16.

Also in this tenth embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated, a good light attenuation ratio is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently, respectively, and the degree of freedom in designing the laser device is enhanced.

Furthermore, the fabricating method of a semiconductor device of this tenth embodiment may be applied not only to a case where MOCVD is used, but also to a case where MBE, gas source MBE, or CBE is used.

### Embodiment 11.

A description is given of an eleventh embodiment of the present invention.

Figure 13 is a cross-sectional view illustrating a fabricating method of a semiconductor device comprising a light modulator and a laser element integrated on a same substrate according to an eleventh embodiment of the present invention. In this eleventh embodiment, the rear surface of the substrate, or the configuration or material of the susceptor is not changed dependent on the places as in the first to tenth embodiments, when growing the active layer 3 on the InP substrate 1, light (arrow of wave line in the figure) is irradiated to a portion on the substrate, and there is produced a temperature difference between this portion and the other portion. As an irradiation light, argon laser light or He-Ne laser light may be used. On the InP substrate 1 thus heated, using the process similar as the process shown in the first embodiment, the semiconductor layer is grown and the laser element and the light modulator are formed.

In this eleventh embodiment, not only the entirety of the InP substrate 1 is heated by the heat which flows through the susceptor 12 by the heater 13, and the portion to which the laser light is irradiated, and this portion is further heated by this light. The temperature of this portion becomes higher than the temperature of the other portion. More particularly, the light irradiation portion becomes the high temperature portion 142 and the other portion becomes the low temperature portion. By making the temperature of the high temperature portion higher than the temperature of the low temperature portion by 20 ∼ 25 °C at the growth of the active layer, the active layer of the light modulator of wavelength 1.49 µm is formed at the high temperature portion and the active layer of the semiconductor laser element of wavelength of 1.55 µm at the low temperature portion. The semiconductor layer grown on the high temperature portion becomes the laser element portion 15 and the semiconductor layer grown on the high temperature portion of the substrate becomes the light modulator portion 16.

Also in this eleventh embodiment, as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated by the light modulator, a good light attenuation ratio is obtained. Particularly, a good light attenuation ration of 10 dB is obtained in the light modulator fabricated by the method of the eleventh embodiment. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently respectively, and the degree of freedom in designing the laser device is enhanced.

Furthermore, the fabricating method of a semiconductor device of this eleventh embodiment may be applied not only to a case where MOCVD is used, but also to a case where MBE, gas source MBE, or CBE is used.

### Embodiment 12.

A description is given of a twelfth embodiment of the present invention.

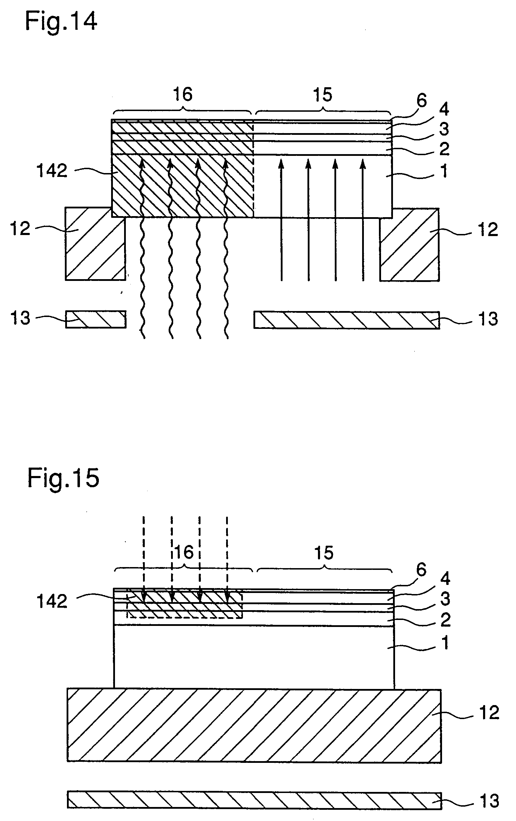

Figure 14 is a cross-sectional view illustrating a fabricating method of a semiconductor device comprising a light modulator and a laser element integrated on a same substrate according to a twelfth embodiment of the present invention. In this twelfth embodiment, the light irradiation in the eleventh embodiment is performed not from the surface side of the InP substrate 1 but from the rear surface side. More particularly, as shown in figure 14, the susceptor 12 is made to support only the peripheral part of the substrate 1, and further an aperture part through which the irradiation light passes through is provided at the heater 13, and when, growing the active layer 3, light (arrow of wave line in the figure) is irradiated to a portion of the substrate from the rear surface side of the substrate 1 through the heater aperture, thereby producing a temperature difference between this portion and the other portion of the substrate. As the irradiation light, such as argon laser light or He-Ne laser light may be used. On the InP substrate 1 thus heated, using the process similar as the process described in the first embodiment, a semiconductor layer is grown and the laser element and the light modulator are formed.

In this twelfth embodiment, not only the InP substrate 1 is heated by the emitted heat from the heater 13, but the portion which is irradiated with the laser light is heated by light, whereby the temperature of this portion becomes higher than the temperature of the other portion. More particularly, the portion which is irradiated with the light becomes the high temperature portion 142 and the other portion becomes the low temperature portion. By making the temperature of the high temperature portion higher than the temperature of the low temperature portion by 20 ∼ 25 °C at the growth of the active layer, an active layer of the light modulator of wavelength 1.49 µm is grown at the high temperature portion and an active layer of laser element of wavelength of 1.55 µm at the low temperature portion. The semiconductor layer grown on the low temperature portion becomes the laser element portion 15 and the semiconductor layer grown on the high temperature portion becomes the light modulator portion 16.

Also in this twelfth embodiment, similarly as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated by the light modulator, a good light attenuation ratio is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently respectively, and the degree of freedom in designing the laser device is enhanced.

Furthermore, the fabricating method of a semiconductor device of this twelfth embodiment may be applied not only to a case where MOCVD is used, but also to a case where MBE, gas source MBE, or CBE is used.

### Embodiment 13.

A description is given of an thirteenth embodiment of the present invention.

Figure 15 is a cross-sectional view illustrating a fabricating method of a semiconductor device comprising a light modulator and a laser element integrated on a same substrate according to a thirteenth embodiment of the present invention. In this thirteenth embodiment, an electron beam is employed in place of the light in the eleventh embodiment. More particularly, as shown in figure 15, when growing the active layer 3 on the InP substrate 1, an electron beam (an arrow of dotted line in the figure) is irradiated to a portion of the substrate, and a temperature difference is produced between this portion and the other portion. However, this embodiment can be applied only to cases where the growth of semiconductor layers are performed in the high vacuum as in MBE, gas source MBE, and CBE. On the InP substrate 1 thus heated, using the process similar as the process shown in the first embodiment, the semiconductor layer is grown and the laser element and the light modulator are formed.

In this thirteenth embodiment, not only the entirety of the InP substrate 1 is heated by the heat which flows through the susceptor 12 from the heater 13, but the portion which is irradiated with the electron beam is further heated by this electron beam, and the temperature of this portion becomes higher than the temperature of the other portion. In other words, the portion which is irradiated with light becomes the high temperature portion 142 and the other portion becomes the low temperature portion. By making the temperature of the high temperature portion higher than the temperature of the low temperature portion by 20 ∼ 25 °C at the growth of the active layer, the active layer of the light modulator of wavelength 1.49 µm is formed at the high temperature portion and the active layer of the semiconductor laser element of wavelength of 1.55 µm at the low temperature portion. The semiconductor layer grown on the high temperature portion becomes the laser element portion 15 and the semiconductor layer grown on the high temperature portion of the substrate becomes the light modulator portion 16.

Also in this thirteenth embodiment, similarly as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated by the light modulator, a good light attenuation ratio is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently respectively, and the degree of freedom in designing the laser device is enhanced.

### Embodiment 14.

A description is given of an fourteenth embodiment of the present invention.

Figure 15 is a cross-sectional view illustrating a fabricating method of a semiconductor device comprising a light modulator and a laser element integrated on a same substrate according to a fourteenth embodiment of the present invention. In this fourteenth embodiment, the electron beam irradiation in the thirteenth embodiment is performed not from the surface side of the InP substrate 1 but from the rear surface side. More particularly, as shown in figure 16, the susceptor 12 is made to support only the peripheral part of the substrate 1, and further an aperture part through which the irradiation electron beam passes through is provided at the heater 13, and when growing the active layer 3, electron beam (arrow of wave line in the figure) is irradiated to a portion of the substrate from the rear surface side of the substrate 1 through the heater aperture, thereby producing a temperature difference between this portion and the other portion of the substrate. As the irradiation light, such as argon laser light or He-Ne laser light may be used. On the InP substrate 1 thus heated, using the process similar as the process described in the first embodiment, a semiconductor layer is grown and the laser element and the light modulator are formed.

In this fourteenth embodiment, not only the InP substrate 1 is heated by the irradiated heat from the heater 13, but the portion which is irradiated with electron beam is further heated by electron beam, whereby the temperature of this portion becomes higher than the temperature of the other portion. More particularly, the portion which is irradiated with electron beam becomes the high temperature portion 142 and the other portion becomes the low temperature portion. By making the temperature of the high temperature portion higher than the temperature of the low temperature portion by 20 ∼ 25 °C at the growth of the active layer, an active layer of the light modulator of wavelength 1.49 µm is grown at the high temperature portion and an active layer of laser element of wavelength of 1.55 µm at the low temperature portion. The semiconductor layer grown on the low temperature portion becomes the laser element portion 15 and the semiconductor layer grown on the high temperature portion becomes the light modulator portion 16.

Also in this fourteenth embodiment, similarly as in the first embodiment, the compositions of the semiconductor layers which are grown on the two portions of the InP substrate 1 can be made to different, and the laser element can be formed from the semiconductor layer grown at the low temperature part and the light modulator part can be formed from the semiconductor layer grown at the high temperature part. Meanwhile, the composition of InGaAsP of the active layer can be controlled with high precision, and when the laser light from the laser element is modulated by the light modulator, a good light attenuation ratio is obtained. In addition, the surface of the semiconductor layer after the growth becomes flat and the fabrication process performed thereafter can be made to stable. In addition, by controlling the growth temperature, the composition of InGaAsP constituting the active layer can be controlled at the laser element part and the modulator part independently respectively, and the degree of freedom in designing the laser device is enhanced.

## Claims

1. A method for fabricating a semiconductor device comprising:
a) preparing a semiconductor substrate (1) having a first surface with partial regions (141, 142) whose temperatures are different from one another;
b) growing a III-V group compound semiconductor layer (3) on the first surface of said semiconductor substrate (1), so that respective partial regions of said semiconductor layer (3) have different compositions from one another.

2. The method of Claim 1 wherein the growth of said III-V group compound semiconductor layer (3) is carried out by metal organic chemical vapor deposition.

3. The method of Claim 1, wherein the growth of said III-V group compound semiconductor layer is performed on a first partial region (142) having a first temperature and a second partial region (141) adjacent thereto having a second temperature lower than said first temperature, and
said method further comprises after step (b), the step:
c) forming an optical waveguide extending over said first partial region (142) and said second partial region (141), and a light modulator (16) having said optical waveguide in said first partial region (142) and a laser element (15) having said optical waveguide in said second partial region (141).

4. The method of Claim 3, wherein the semiconductor substrate is an n type InP substrate (1), and the growth of the semiconductor layer forming the light waveguide comprises successively growing an n type InP cladding layer (2), an active layer (3), a p type InP cladding layer (4), and a p type InGaAs contact layer (6).

5. The method of Claim 3, wherein the semiconductor substrate is an n type InP substrate (1), the growth of the semiconductor layer forming the light waveguide comprises successively growing an n type InP cladding layer (2), an n type InGaAsP guide layer (51), an active layer (3), an InGaAsP guide layer (52), a p type InP cladding layer (4), and a p type InGaAs contact layer (6).

6. The method of Claim 1, wherein the reflectivity to the thermal radiation when heating the substrate the second opposite surface of said semiconductor substrate (1) is made different within the partial regions, thereby making the partial regions (141, 142) of said first surface have said different temperatures, the region having a higher reflectivity having a lower temperature.

7. The method of Claim 6, wherein the second surface of said semiconductor substrate (1) includes a first partial region (142) having a mirror surface (112) and a second partial region (141) having a fine surface including a concavo-convex structure (111), disposed adjacent said first partial region (142), and the reflectivity to thermal radiation in said first partial region (142) of said rear surface is made higher than in the second partial region (141).

8. The method of Claim 6, wherein a reflective film (30) is formed on one partial region (141) of said second surface of said semiconductor substrate (1) so as to make the reflectivity to the thermal radiation higher for said one partial region (141) than for the surrounding partial regions.

9. The method of Claim 6, wherein an anti-reflective (transmissive) film (31) is formed on one partial region (142) of said second surface which is finished to be a mirror surface (112), wherein the reflectivity to the thermal radiation of the other partial regions (141) is higher than that for said one partial region (142).

10. The method of Claim 6, wherein the semiconductor substrate (1) is supported by a susceptor (12) having a recess (23) for receiving the semiconductor substrate (1) therein, the bottom surface of the recess (23) being in contact with the second surface of the semiconductor substrate (1).

11. The method of Claim 6, wherein the semiconductor substrate (1) is supported by a susceptor (12) having a two-stage recess (24a, 24b), the recess adapted to receive said semiconductor substrate (1) with a space between the second surface of the semiconductor substrate (1) and the bottom surface of the two-stage recess (24a, 24b).

12. The method of Claim 1 further comprising:
forming a heat conductive film (32) of a high heat conductivity material on one partial region on a second opposite surface of the semiconductor substrate (1);
supporting the semiconductor substrate (1) by a receptor (12) and heating the semiconductor substrate (1) by thermal conduction from the susceptor (12);
contacting the second surface with the surface of the susceptor (12) via the thermal conductive film (32) at the partial region; and
making the temperature of a corresponding partial region of the first surface of the semiconductor substrate (1) higher than the temperature of the other partial regions of the first surface.

13. The method of Claim 1, wherein said semiconductor substrate (1) comprises a first partial region (142) which is thick and a second partial region which is thin,
said semiconductor substrate (1) is supported by a susceptor (12) and is heated by heat conduction from the susceptor (12),
said first partial region (142) of the second surface is in contact with the surface of said susceptor (12) and said second partial region (141) of the second surface is not directly contacted with the surface of said susceptor (12), and
the temperature of said first partial region (142) is higher than the temperature of said second partial region (141).

14. The method of Claim 1, wherein the second surface of said semiconductor substrate (1) comprises a first partial region (142) having a flat surface (113) and a second partial region (141) having a fine concavo-convex structure (111),
the reflectivity to the thermal radiation of the second surface is the same through said first partial region (142) and said second partial region (141),
said semiconductor substrate (1) is supported by a susceptor (12) with the entire second surface of said semiconductor substrate (1) being in contact with the surface of said susceptor (12),
the heating of said semiconductor substrate (1) is carried out by the thermal conduction and thermal radiation from said susceptor (12), and
the temperature of a partial region of said semiconductor substrate (1) on the first surface, corresponding to said first partial region (142) of the second surface, is made higher than the temperature of another partial region on the first surface corresponding to said second partial region of the second surface.

15. The method of Claim 1, wherein said semiconductor substrate (1) is supported by a susceptor (12) having a recess (25) in a region on its surface smaller than said semiconductor substrate (1) and is heated by the thermal conduction and thermal radiation from said susceptor (12),
the second surface of said semiconductor substrate (1) is in contact with the surface of said susceptor (12) so as to cover said recess (25) while not in contact with the surface of said susceptor (12) in said recess (25),
the temperature of the first surface of said semiconductor substrate (1) is made higher, in a partial region (15), which corresponds to the partial region of the second surface of said semiconductor substrate (1), in contact with the surface of said susceptor (12) than another partial region of the first surface of said semiconductor substrate (1), which corresponds to the hollow portion (25) of said susceptor (12).

16. The method of Claim 1, wherein said semiconductor substrate (1) is supported by a susceptor (12) and is heated by the thermal conduction and thermal radiation from the susceptor (12),
the entire second surface of said semiconductor substrate (1) being in contact with the surface of said susceptor (12), said susceptor (12) comprising a first portion (27) including a first material and a second portion (26) including a second material having a higher conductivity than that of said first material,
the temperature of a partial region (15) of the first surface of said semiconductor substrate (1), which corresponds to the first portion (27) of said susceptor (12) is made higher than that of another partial region of the first surface (1) which corresponds to the second portion (26) of said susceptor (12).

17. The method of Claim 1, wherein a partial region of said semiconductor substrate (1) is irradiated with an Ar laser light or an He-Ne laser light so as to raise the temperature of the partial region (142) relative to the temperature of the other partial region.

18. The method of Claim 1, wherein said semiconductor substrate (1) is supported at its periphery by contact with said susceptor (12), where its portions other than said periphery are not in contact with said susceptor (12), and
said semiconductor substrate (1) is heated by thermal radiation onto one portion (142) of the second surface of said semiconductor substrate (1) and by Ar laser light or an He-Ne laser light irradiation onto another portion of the second surface of said semiconductor substrate (1), whereby the temperature of said other partial region (142) irradiated with the laser light is made higher than the temperature of said one partial region (142).

19. The method of Claim 1, wherein the growth of said III-V group compound semiconductor layer (3) is carried out employing molecular beam epitaxy, gas source molecular beam epitaxy, or a chemical beam epitaxy,
a portion (142) of said semiconductor substrate (1) is irradiated with an electron beam so as to raise the temperature of the partial portion (142) relative to another partial region.

20. The method of Claim 1, wherein said semiconductor substrate (1) is supported at its periphery by contact with said susceptor (12) where its portions other than said periphery are not in contact with said susceptor (12), and
said semiconductor substrate (1) is heated by thermal radiation onto one portion (142) of the second surface of said semiconductor substrate (1) and by irradiation of an electron beam onto another portion of the second surface of said semiconductor substrate (1), whereby the temperature of said other partial region (142) irradiated with electron beam is made higher than the temperature of said one partial region.

21. The method of Claim 5, wherein said process of growing said optical waveguide layer comprises a first growth process of growing a first semiconductor layer including said active layer (3) as an uppermost layer on said semiconductor substrate (1), and growing a grating layer comprising a semiconductor forming a diffraction grating (53) on said first semiconductor layer, and a second growth process of growing a second semiconductor layer including a cladding layer (4) as its uppermost layer on the entire surface and burying said diffraction grating (53),
said method further comprising, after the first growth process and before the second growth process, after coating resist on the grating layer, forming a periodic lattice shaped resist pattern at a region where the laser element (215) is to be formed by interference exposure method, and etching the grating layer using the resist as a mask, thereafter, removing the resist and forming a diffraction grating (53) comprising said grating layer remained below the resist pattern.

22. A semiconductor device including a laser element (215) and a light modulator (216) both comprising III-V group compound semiconductor material and being and formed on a same substrate (1), said device comprising:
an active layer (3) in said laser element (215) and said light modulator (216),
wherein the composition of the semiconductor forming the active layer (3) of said laser element (215) is different from the composition of the semiconductor forming the active layer (3) of said light modulator (216).

23. The semiconductor device of Claim 22, wherein the active layer (3) of said laser element (215) and the active layer (3) of said light modulator (216) include InGaAsP or InGaAs.

24. The semiconductor device of Claim 23, wherein each of said laser element (215) and said light modulator (216) includes optical waveguides being a laminate of an n type InP cladding layer (2), said active layer (3), a p type InP cladding layer (4), and a p type InGaAs contact layer (6), successively.

25. The semiconductor device of Claim 23, wherein each of said laser element (215) and said light modulator (216) includes optical waveguides being a laminate of said n type InP cladding layer (2), an n type GaInAsP guide layer (51), said active layer (3), a GaInAsP guide layer (52), said p type InP cladding layer (4), and a p type InGaAs contact layer (6).

26. The semiconductor device of Claim 23, wherein the wavelength of the laser light oscillation in said laser element (215) is 1.55 µm, and the maximum wavelength of the light absorbed in a state where no bias voltage is applied in said light modulator (216) is 1.49 µm.

27. The semiconductor device of Claim 22, wherein a diffraction grating (53) is provided on the active layer (.3) of the laser element (215).
